# EUROPÄISCHE PATENTSCHRIFT

(11) **EP 3 775 942 B1**
(45) Veröffentlichungstag und Bekanntmachung des Hinweises auf die Patenterteilung: **07.06.2023**
(21) Anmeldenummer: 19717818.9
(22) Anmeldetag: 10.04.2019
(51) Int. Cl.: G01R 21/133, G01R 22/06, H02J 13/00

(54) **ZWISCHENMODUL, EMPFÄNGERMODUL, ÜBERWACHUNGSSYSTEM UND ÜBERWACHUNGSVERFAHREN**
INTERMEDIATE MODULE, RECEIVER MODULE, MONITORING SYSTEM AND MONITORING METHOD
MODULE INTERMÉDIAIRE, MODULE RÉCEPTEUR, SYSTÈME DE SURVEILLANCE ET PROCÉDÉ DE SURVEILLANCE

(30) Priorität: 11.04.2018 DE 102018205492
(43) Veröffentlichungstag der Anmeldung: 17.02.2021
(73) Patentinhaber: TRUMPF Werkzeugmaschinen SE + Co. KG, 71254 Ditzingen (DE)
(72) Erfinder: KIEFER, Manuel, 74889 Sinsheim (DE); DEISS, Magnus, 70372 Stuttgart (DE)
(74) Vertreter: Trumpf Patentabteilung
(86) Internationale Anmeldenummer: PCT/EP2019/059036
(87) Internationale Veröffentlichungsnummer: WO 2019/197443

(56) Entgegenhaltungen:
- DE-A1- 4 425 876
- DE-A1-102016 113 028
- DE-U1-202010 000 364
- US-A1- 2014 046 495

## Beschreibung

Die Erfindung betrifft ein Zwischenmodul zum Zwischenschalten zwischen ein Stromnetz und einen elektrischen Verbraucher in Verbindung mit einem Empfängermodul zum Empfangen von Informationen über Betriebsdaten eines Verbrauchers aus einem Stromnetz. In den Rahmen der Erfindung fällt ein derartiges Überwachungssystem mit einem Zwischenmodul und einem Empfängermodul. Schließlich betrifft die Erfindung eine Verwendung eines Überwachungssystems zum Überwachen eines elektrischen Verbrauchers und ein Verfahren zum Überwachen einer Fertigungsmaschine in einem Fertigungsbetrieb.

Für Haushaltsanwendungen sind fest installierte "intelligente" Stromzähler, sogenannte Smart-Meter, bekannt, die es erlauben, den Stromverbrauch einer Gesamtheit von elektrischen Verbrauchern zu messen und zu protokollieren.

Um eine gezielte Überwachung einzelner elektrischer Verbraucher nachträglich einrichten zu können, wurden verschiedene Adapter vorgeschlagen, die zwischen ein einphasiges Stromnetz und einen elektrischen Verbraucher geschaltet werden können. Mit diesen Adaptern kann der Stromverbrauch beispielsweise eines Kühlschranks oder eines Fernsehers erfasst und mittels geeigneter Programme dargestellt werden.

In Fertigungsbetrieben ist es oft wünschenswert, die Betriebszustände von Fertigungsmaschinen, welche mit Starkstrom betrieben werden, überwachen zu können. Insbesondere besteht das Bedürfnis, aus der Ferne überwachen und aufzeichnen zu können, ob und ggf. welche Fertigungsoperationen mit einer Fertigungsmaschine durchgeführt wurden. Nach Auswertung dieser Informationen können der Einsatz der Produktionsmittel und Wertschöpfungsprozesse optimiert werden. Für diese Überwachungsaufgaben werden gegenwärtig maschinenspezifische Überwachungssysteme eingesetzt, die fest an eine jeweilige Fertigungsmaschine angeschlossen sind.

Relevanter Stand der Technik wird offenbart in DE 20 2010 000364 U1, DE 10 2016 113028 A1, DE 44 25 876 A1 und US 2014/046495 A1.

### Aufgabe der Erfindung

Es ist daher Aufgabe der Erfindung, Vorrichtungen und Verfahren zur flexiblen und nachrüstbaren Überwachung von elektrischen Verbrauchern an Starkstromnetzen anzugeben.

### Beschreibung der Erfindung

Diese Aufgabe wird erfindungsgemäß gelöst durch ein Überwachungssystem gemäß Anspruch 1, eine Verwendung eines Überwachungssystems gemäß Anspruch 14 sowie ein Verfahren zum Überwachen einer Fertigungsmaschine in einem Fertigungsbetrieb gemäß Anspruch 15.

In den jeweiligen Unteransprüchen sind bevorzugte Ausführungsformen und Varianten angegeben.

### Erfindungsgemäße Zwischenmodule

Erfindungsgemäß ist ein Zwischenmodul zum Zwischenschalten zwischen ein Stromnetz und einen elektrischen Verbraucher, mit einem Eingangs-Stromanschluss zum Anschließen des Zwischenmoduls an das Stromnetz, und mit einem Ausgangs-Stromanschluss zum Anschließen des Verbrauchers an das Zwischenmodul vorgesehen. Das Zwischenmodul ist dazu eingerichtet, Betriebsdaten des Verbrauchers zu ermitteln und über den Eingangs-Stromanschluss Informationen über die ermittelten Betriebsdaten in das Stromnetz zu übertragen. Der Eingangs-Stromanschluss weist drei Außenleiter-Eingangskontakte zum Kontaktieren je eines Außenleiters des Stromnetzes auf. Das Zwischenmodul ist somit dazu eingerichtet, einen Verbraucher an ein dreiphasiges Stromnetz anzuschließen. Damit eignet sich das erfindungsgemäße Zwischenmodul auch für einen Einsatz an Fertigungsmaschinen, die mit Starkstrom betrieben werden. Durch die Übermittlung der ermittelten Betriebsdaten über das Stromnetz kann auf die Einrichtung einer gesonderten Übertragungsinfrastruktur verzichtet werden - kabelgebundene Lösungen hierzu sind aufwendig zu installieren; drahtlose Varianten sind beim Einsatz in industriellen Fertigungshallen störanfällig. Das erfindungsgemäße Zwischenmodul kann somit in einfacher Weise zwischen einen elektrischen Verbraucher, insbesondere eine Fertigungsmaschine, und ein dreiphasiges Stromnetz, insbesondere ein Starkstromnetz, geschaltet werden. Sodann ermöglicht das Zwischenmodul eine Überwachung von Betriebszuständen des Verbrauchers, indem es dessen Betriebsdaten ermittelt und Informationen hierüber in das Stromnetz überträgt.

Ein Außenleiter (auch bekannt unter "Phase") ist ein Leiter, der im üblichen Betrieb unter Spannung gegenüber einem Neutralleiter steht und zur Übertragung oder Verteilung elektrischer Energie beitragen kann, aber kein Neutralleiter (Mittelleiter) ist. Bei einphasigen Anschlüssen mit einer Nennspannung von 230 V tritt er nur einfach auf und trägt häufig die Bezeichnung "L". Ein dreiphasiges Stromnetz weist drei Außenleiter auf, die meist mit L1, L2 und L3 bezeichnet werden. Im Niederspannungsnetz, an das Verbraucher angeschlossen werden, beträgt der Effektivwert der Spannung von Außenleitern in der Regel 230 V gegen den Neutralleiter und einen allfällig vorhandenen Schutzleiter und 400 V zwischen je zwei Außenleitern bei einer Phasendifferenz von 120° zwischen den Wechselspannungen der drei Außenleiter. Das Stromnetz, insbesondere das Niederspannungsnetz, weist typischerweise eine Frequenz zwischen 50 Hz und 60 Hz auf. In Europa weist der Neutralleiter üblicherweise keine Spannung gegenüber dem Schutzleiter und der Erde auf, so dass alle Außenleiter eine Spannung von 230 V gegenüber der Erde aufweisen. Beim Anschluss des Verbrauchers an alle drei Phasen (Außenleiter) des Niederspannungsnetzes wird von einem Starkstromanschluss gesprochen.

Das Zwischenmodul ist insbesondere dazu eingerichtet, die Betriebsdaten selbst zu messen und/oder zu berechnen. Das Zwischenmodul ist typischerweise dazu eingerichtet, die Betriebsdaten durch Überwachung der Außenleiter-Eingangskontakte zu ermitteln, insbesondere durch Messen von Stromstärken durch die Außenleiter-Eingangskontakte und/oder von Spannungen zwischen den Außenleiter-Eingangskontakten. Die Informationen über die Betriebsdaten können die Zahlenwerte der Betriebsdaten, d.h. sozusagen die Betriebsdaten selbst, sein und/oder von dem Zwischenmodul aus den ermittelten Betriebsdaten abgeleitete Parameter. Beispiel: Messen von Strom und Spannung in dem Zwischenmodul; Übermitteln des gemessenen Stromverlaufs (1. Variante) bzw. Übermitteln des berechneten Energieverbrauchs (2. Variante). Zur Übertragung der Informationen kann ein OFDM-Verfahren (OFDM = Orthogonal Frequency-Division Multiplexing) vorgesehen sein.

Der Verbraucher kann eine Fertigungsmaschine sein, insbesondere eine Fertigungsmaschine, die wenig oder gar nicht digitalisert an eine Dateninfrastruktur eines Fertigungsbetriebs angeschlossen ist. Die Fertigungsmaschine kann an einem Handarbeitsplatz eingesetzt werden und beispielsweise ein Schweißgerät sein. Ein Handarbeitsplatz ist eine Produktions- bzw. Fertigungsanlage mit einem geringen Automatisierungsgrad und einem hohen Handarbeitsanteil. Im Wesentlichen umfasst ein Handarbeitsplatz eine Werkbank/Arbeitsfläche und meist mehrere Werkzeuge, die durch einen Bediener nach Anweisung oft frei Hand bedient werden. Durch den geringen Automatisierungsgrad kann es zu Störungen und Mehraufwand im Prozessablauf kommen, da hier neben der eigentlichen Fertigung oder Bearbeitung eines Werkstücks weitere Nebentätigkeiten anfallen, wie das manuelle Erstellen von Arbeitsanweisungen, das Ausdrucken und Aneignen von Erklärungen, Anweisungen und Zeichnungen. Zudem herrscht oft ein hoher Fertigungsaufwand. Daraus und aus unzureichenden oder zu komplexen Arbeitsunterlagen, fehlender Rückmeldung über den Arbeitsfortschritt und allgemein einer fehlenden Zustandsüberwachung und -diagnose von Werkzeugen und Maschinen kann ein hoher Ausschuss resultieren. Das erfindungsgemäße Zwischenmodul kann hier in einfacher Weise nachgerüstet werden und liefert dann die gewünschten Daten zur Fertigung an dem Handarbeitsplatz.

Eine Fertigungsmaschine kann eine Maschine zur Blech- oder Metallbearbeitung sein. Anders als in anderen Fertigungs- oder Logistikbetrieben, die oftmals entweder gar nicht oder hochgradig bis vollständig digitalisiert verknüpft sind, trifft man in Fertigungsbetrieben der Metall- und/oder Blechbearbeitung häufig auf einen mittleren Digitalisierungsgrad. Das bedeutet, dass viele hochgradig digital vernetzte Maschinen wie z.B. CNC-Metallbearbeitungsmaschinen, Flachbett-Schneid-, Biege- oder Stanzmaschinen der neueren Generation als auch wenig bis gar nicht vernetzte Fertigungsmaschinen (wie z.B. einfache elektrische Sägen, Bohrmaschinen, Nietwerkzeuge, Fräsmaschinen) vorhanden sind. Die älteren Maschinen haben oftmals eine sehr lange Standzeit und Haltbarkeit sowie Zuverlässigkeit und werden von Werkbetriebsleitern nur ungern gegen eine neue vollautomatische Maschine ausgetauscht. Das erfindungsgemäße Zwischenmodul ermöglicht die Einbindung der älteren, bewährten Maschinen in ein digitales Überwachungs- und Steuerungssystem des Fertigungsbetriebs. Wenn noch kein digitales Überwachungs- und Steuerungssystem im Fertigungsbetrieb vorhanden ist, kann es mit Hilfe des erfindungsgemäßen Zwischenmoduls schnell und kostengünstig aufgebaut werden. Wenn bereits eine teilweise Digitalisierung erfolgt ist, können bisher noch nicht digitalisierte Fertigungsmaschinen mit dem erfindungsgemäßen Zwischenmodul für die Einbindung in dieses Überwachungs- und Steuerungssystem ertüchtigt werden.

Insbesondere besteht beim erstmaligen Einsatz von erfindungsgemäßen Zwischenmodulen - im Gegensatz zum konventionellen Ersteinsatz von Digitalisierungslösungen - kein Risiko des Stillstands der Fertigungsmaschinen. Das Zwischenmodul wird lediglich zwischen die Fertigungsmaschine und das Stromnetz geschaltet und leitet den Strom durch. Sollte das digitale Überwachungssystem nicht funktionieren hat dies keine Auswirkungen auf die Betriebsbereitschaft der Fertigungsmaschine, da diese zunächst wie bisher - d.h. undigitalisiert - weiterbetrieben werden kann.

Vorzugsweise weist der Eingangs-Stromanschluss weiterhin einen Neutralleiter-Eingangskontakt zum Kontaktieren eines Neutralleiters des Stromnetzes und/oder einen Schutzleiter-Eingangskontakt zum Kontaktieren eines Schutzleiters des Stromnetzes auf. Durch den sog. Massebezug, d.h. den Anschluss an den Neutralleiter, kann eine verbesserte Störunempfindlichkeit erreicht werden. Zudem kann ein Ausgleich einer unsymmetrischen Belastung der drei Außenleiter durch den Verbraucher erfolgen.

In einer vorteilhaften Ausführungsform ist das Zwischenmodul dazu eingerichtet, die Informationen über die Betriebsdaten über genau einen der Außenleiter-Eingangskontakte zu übertragen. Dies vereinfacht den Aufbau des Zwischenmoduls.

Eine dazu alternative, vorteilhafte Ausführungsform sieht vor, dass das Zwischenmodul dazu eingerichtet ist, die Informationen über die Betriebsdaten über wenigstens zwei, vorzugsweise über alle, Außenleiter-Eingangskontakte zu übertragen. Diese Alternative bietet eine Redundanz und erhöht die Robustheit der Informationsübertragung. Eine Empfangsstation kann die Informationen über die Betriebsdaten auf einem beliebigen der mehreren Außenleiter des Stromnetzes empfangen. Bei Übertragung über alle Außenleiter-Eingangskontakte kann die Empfangsstation insbesondere auch an eine einphasige Steckdose desselben Stromnetzes angeschlossen werden, unabhängig davon, welcher der drei Außenleiter in diese Steckdose mündet.

Bei einer vorteilhaften Ausführungsform ist der Eingangs-Stromanschluss als ein Zwischenmodul-Stecker zum Einstecken in eine Steckdose ausgebildet, insbesondere wobei die Eingangskontakte des Eingangs-Stromanschlusses jeweils als ein Steckerstift ausgebildet sind. Dies erlaubt eine besonders einfache Implementierung im Sinne einer sog. Plug&Play-Lösung; es ist kein Serviceeinsatz notwendig. Zudem kann das Zwischenmodul einfach ausgewechselt oder an einem anderen Verbraucher eingesetzt werden. Diese Ausführungsform eignet sich insbesondere für ortsveränderliche Fertigungsmaschinen, die an unterschiedlichen Orten an das Stromnetz angeschlossen werden sollen. Ein Schutz gegen Störungen (Dämpfungsdrosseln, Ferrite, Überspannungsbegrenzer etc.) kann mit in das Zwischenmodul integriert werden.

In einer alternativen Ausführungsform kann eine individuelle Verdrahtung des Eingangs-Stromanschlusses mit den Leitern des Stromnetzes vorgesehen sein, beispielsweise wenn das Zwischenmodul in einem Schaltschrank oder einer Medien-Säule zu montieren ist, etwa mittels einer Hutschienen-Montage.

Besonders bevorzugt weist der Ausgangs-Stromanschluss je einen zugeordneten Ausgangskontakt für jeden der Eingangskontakte des Eingangs-Stromanschlusses auf. Dies vereinfacht das Anschließen des Verbrauchers an das Zwischenmodul. Jeder der Ausgangskontakte ist grundsätzlich mit dem jeweils zugeordneten Eingangskontakt elektrisch leitend verbunden. Mit anderen Worten umfasst der Ausgangs-Stromanschluss bei dieser Ausführungsform drei Außenleiter-Ausgangskontakte. Sofern der Eingangs-Stromanschluss einen Neutralleiter-Eingangskontakt bzw. einen Schutzleiter-Eingangskontakt aufweist, umfasst der Ausgangs-Stromanschluss weiterhin einen Neutralleiter-Ausgangskontakt und/oder einen Schutzleiter-Ausgangskontakt.

Besonders bevorzugt ist der Ausgangs-Stromanschluss als eine Zwischenmodul-Steckdose zum Einstecken eines Steckers ausgebildet, insbesondere wobei die Ausgangskontakte des Ausgangs-Stromanschlusses jeweils als eine Einsteckbuchse ausgebildet sind. Der Verbraucher kann dann besonders einfach angeschlossen werden.

Erfindungsgemäß ist das Zwischenmodul dazu eingerichtet, wenigstens einen Parameter eines elektrischen Stroms zu messen, der im Betrieb von dem Stromnetz durch das Zwischenmodul zu dem Verbraucher fließt. Dies erlaubt eine präzise Ermittlung der Betriebsdaten. Zu messende Parameter können insbesondere sein: Stromstärke, Spannung, Phasenverschiebung, Lastspitzen, Oberschwingungen. Je nach Parameter kann die Messung für jedes Paar von Außenleiter-Eingangskontakt und zugeordnetem Außenleiter-Ausgangskontakt separat oder für alle Paare von Außenleiter-Eingangskontakt und zugeordnetem Außenleiter-Ausgangskontakt gemeinsam erfolgen.

Besonders bevorzugt ist vorgesehen, dass das Zwischenmodul dazu eingerichtet ist, die Betriebsdaten zeitaufgelöst zu ermitteln, und dass die Information über die ermittelten Betriebsdaten Zeitinformationen umfassen. Mit anderen Worten werden die Informationen über die Betriebsdaten von dem Zwischenmodul mit Zeitstempeln versehen. Dadurch werden zusätzliche Möglichkeiten der Analyse und Steuerung eröffnet.

Das Zwischenmodul kann dazu eingerichtet sein, über den Eingangs-Stromanschluss Befehle aus dem Stromnetz entgegenzunehmen. Die Befehle können beispielsweise angeben, wie die Informationen über die Betriebsdaten von dem Zwischenmodul ermittelt werden sollen und/oder welche Informationen vom Zwischenmodul ins Stromnetz übertragen werden sollen. Die Befehle können auch dazu dienen, den Verbraucher zu steuern, beispielsweise abzuschalten oder in einen andern Betriebsmodus umzuschalten.

Das Zwischenmodul kann eine LAN- und/oder WLAN-Schnittstelle aufweisen. Eine solche Schnittstelle ist insbesondere zur Konfiguration des Zwischenmoduls oder zum Anschließen von Zusatzgeräten, z.B. einer Kamera oder einer Lichtschranke, nützlich.

Erfindungsgemäß weist das Zwischenmodul einen Anschluss, vorzugsweise eine USB-Schnittstelle, für eine Kamera, auf und ist dazu eingerichtet, ein von der Kamera empfangenes Bild in das Stromnetz zu übertragen. Über das von der Kamera aufgenommene Bild kann der an das Zwischenmodul angeschlossene Verbraucher identifiziert werden. Zudem kann die Übertragung des Bildes eine optische Fernüberwachung einer Umgebung des Zwischenmoduls ermöglichen.

In weiteren vorteilhaften Ausführungsformen kann das Zwischenmodul folgendes je einzeln oder in beliebigen Kombinationen umfassen:
- einen oder mehrere analoge Eingänge (z.B. 0-10 V, 4-20 mA),
- einen oder mehrere digitale Eingänge (z.B. 24 V),
- einen oder mehrere Schaltausgänge (z.B. 24 V oder 230 V),
- eine oder mehrere USB-Schnittstellen, z.B. zum Anschließen einer Kamera, insbesondere einer Webcam,
- einen Temperatursensor und/oder einen Feuchtigkeitssensor.

Das Zwischenmodul ist dann grundsätzlich dazu eingerichtet, über den Eingang bzw. die Eingänge bzw. die Schnittstelle(n) empfangene oder von dem Sensor bzw. den Sensoren gemessene Daten über den Eingangs-Stromanschluss in das Stromnetz zu übertragen. Der Temperatursensor und/oder der Feuchtigkeitssensor können Informationen für eine Einrichtung zur Klimatisierung der Umgebung des Verbrauchers liefern, so dass diese ggf. nachgeregelt werden kann.

### Erfindungsgemäße Empfängermodule

In den Rahmen der Erfindung fällt auch ein Empfängermodul zum Empfangen von Informationen über Betriebsdaten eines Verbrauchers aus einem Stromnetz, mit einem Empfänger-Stromanschluss zum Anschließen des Empfängermoduls an das Stromnetz, und mit einer Verarbeitungseinrichtung, die in direktem elektrischem Kontakt mit dem Empfänger-Stromanschluss steht, und die dazu eingerichtet ist, über den Empfänger-Stromanschluss die Informationen über die Betriebsdaten aus dem Stromnetz zu empfangen und die Informationen über die Betriebsdaten zu speichern und/oder auszuwerten. Das Empfängermodul kann über den Empfänger-Stromanschluss an ein Stromnetz angeschlossen werden, insbesondere an ein Stromnetz, an das auch ein oder mehrere erfindungsgemäße Zwischenmodule angeschlossen sind. Der Empfänger-Stromanschluss kann für einen einphasigen oder mehrphasigen, insbesondere dreiphasigen, Anschluss an einen oder mehrere, insbesondere alle, Außenleiter des Stromnetzes ausgebildet sein.

Wenn die Verarbeitungseinrichtung zur Auswertung der Informationen eingerichtet ist, ist sie vorzugsweise auch zum Speichern des Auswertungsergebnisses eingerichtet. Das Speichern im Zwischenmodul erlaubt eine zeitverzögerte oder gesammelte Übermittlung an eine externe Stelle oder ein gelegentliches Auslesen mittels eines Lesegeräts. Die Verarbeitungseinrichtung kann weiterhin dazu eingerichtet sein, die Informationen über die Betriebsdaten weiterzuleiten, etwa mittels LAN, WLAN und/oder Mobilfunk, z.B. GSM-Netz. Wenn die Informationen nur in dem Empfängermodul gespeichert werden und nicht nach außen übermittelt werden, kann einem unbefugten Zugriff auf diese Informationen wirksam vorgebeugt werden.

Bevorzugt ist das Empfängermodul dazu eingerichtet, Nachrichten betreffend die Informationen über die Betriebsdaten an ein Mobilgerät eines Benutzers zu senden. Dies erleichtert einem Benutzer die Überwachung des Verbrauchers. Dazu kann das Empfängermodul eine Kommunikationseinrichtung, beispielsweise einen Chatbot, aufweisen.

Besonders bevorzugt ist das Empfängermodul dazu eingerichtet, Befehle entgegenzunehmen, insbesondere von einem Mobilgerät eines Benutzers, und diese Befehle über den Empfänger-Stromanschluss in das Stromnetz zu übermitteln. Dies ermöglicht einem Benutzer ein an das Stromnetz angeschlossenes Zwischenmodul oder einen über das Zwischenmodul angeschlossenen Verbraucher zu steuern. Dazu kann das Empfängermodul eine Kommunikationseinrichtung, beispielsweise einen Chatbot, aufweisen.

### Erfindungsgemäße Überwachungssysteme

Ebenfalls in den Rahmen der Erfindung fällt ein Überwachungssystem zum Überwachen eines elektrischen Verbrauchers, umfassend
- ein Stromnetz mit drei Außenleitern,
- ein erfindungsgemäßes Zwischenmodul, über welches der Verbraucher an das Stromnetz anschließbar ist,
- ein Empfängermodul zum Empfangen von Informationen über Betriebsdaten des Verbrauchers aus dem Stromnetz,
wobei das Empfängermodul einen Empfänger-Stromanschluss zum Anschließen des Empfängermoduls an das Stromnetz, und eine Verarbeitungseinrichtung aufweist, die dazu eingerichtet ist, über den Empfänger-Stromanschluss die Informationen über die Betriebsdaten aus dem Stromnetz zu empfangen. Das Überwachungssystem ermöglicht die Überwachung und ggf. Steuerung eines Verbrauchers an einem dreiphasigen Stromnetz. Die besonderen Vorteile des erfindungsgemäßen Zwischenmoduls werden in dem Überwachungssystem nutzbar gemacht. Das Stromnetz umfasst typischerweise auch einen Neutralleiter und/oder einen Schutzleiter. Der Verbraucher ist typischerweise auf eine Versorgung mit dreiphasigem Drehstrom (Starkstrom) angewiesen; er kann eine Fertigungsmaschine sein. Das Überwachungssystem kann den Verbraucher umfassen. Der Verbraucher kann ortsveränderlich sein, d.h. an verschiedenen Orten an das Stromnetz anschließbar sein. Vorzugsweise ist das Empfängermodul ein erfindungsgemäßes Empfängermodul, so dass auch dessen spezifische Vorteile ausgenutzt werden können.

In einer bevorzugten Ausführungsform ist vorgesehen, dass das Stromnetz weiterhin einen Neutralleiter umfasst, dass der Empfänger-Stromanschluss des Empfängermoduls einen, insbesondere genau einen, Empfänger-Außenleiterkontakt zum Verbinden des Empfängermoduls mit einem der Außenleiter des Stromnetzes und einen Empfänger-Neutralleiterkontakt zum Verbinden des Empfängermoduls mit dem Neutralleiter des Stromnetzes aufweist. Dies vereinfacht das Anschließen des Empfängermoduls an das Stromnetz.

Das Überwachungssystem kann weiterhin einen Phasenkoppler umfassen, der dazu eingerichtet ist, Informationen die in einem der Außenleiter des Stromnetzes übertragen werden, auf alle anderen Außenleiter des Stromnetzes weiterzuleiten. Dies ist insbesondere nützlich, wenn das Zwischenmodul dazu eingerichtet ist, die Informationen über die Betriebsdaten nur über einen der Außenleiter-Eingangskontakte zu übertragen.

### Inbetriebnahmeverfahren

Ein Beispiel, welches nicht unter den Schutzumfang der Erfindung fällt, betrifft ein Verfahren zur Inbetriebnahme eines erfindungsgemäßen Zwischenmoduls mit einem Anschluss für eine Kamera mit den Schritten
a) Anschließen des Zwischenmoduls an ein Stromnetz mit drei Außenleitern,
b) Anschließen eines elektrischen Verbrauchers an das Zwischenmodul,
c) Anschließen einer Kamera an das Zwischenmodul,
d) Aufnehmen eines Bildes des Verbrauchers mit der Kamera,
e) Übertragen des Bildes in das Stromnetz vermittels des Zwischenmoduls,
f) Abgleichen des Bildes mit weiteren Bildern bekannter Verbrauchertypen, um den Verbraucher zu identifizieren,
g) Speichern der Zuordnung des Zwischenmoduls und des erkannten Verbrauchertyps.

Dieses Verfahren vereinfacht das sog. Pairing, d.h. das Zuordnen des Zwischenmoduls zu dem Verbraucher. Schritt b) muss nicht unmittelbar nach Schritt a) ausgeführt werden. Die Schritte c) und d) können auch in umgekehrter Reihenfolge ausgeführt werden. Für die Schritte f) und g) kann eine Datenbank vorgesehen sein, beispielsweise in einem Empfängermodul, das an das Stromnetz angeschlossen ist, oder in einem Server oder einer Cloudanwendung.

### Verwendungen eines Zwischenmoduls

Ein weiteres Beispiel, welches nicht unter den Schutzumfang der Erfindung fällt, betrifft eine Verwendung eines erfindungsgemäßen Zwischenmoduls zum Überwachen eines elektrischen Verbrauchers, wobei der Verbraucher über das Zwischenmodul an ein Stromnetz mit drei Außenleitern angeschlossen ist, insbesondere wobei der Verbraucher eine Fertigungsmaschine ist. Diese Verwendung des erfindungsgemäßen Zwischenmoduls ermöglicht es auf einfache Weise, einen Verbraucher an einem dreiphasigen Stromnetz, d.h. einen Verbraucher mit Starkstromanschluss, zu überwachen. Das Stromnetz ist typischerweise ein Stromnetz eines Fertigungsbetriebs, an das mehrere Fertigungsmaschinen angeschlossen sind, wobei vorzugsweise jede der Fertigungsmaschinen über ein erfindungsgemäßes Zwischenmodul an das Stromnetz angeschlossen ist. Der Verbraucher hat typischerweise eine maximale elektrische Leistungsaufnahme von wenigstens 3 kW, vorzugsweise wenigstens 5 kW. Die Fertigungsmaschine kann insbesondere eine Werkzeugmaschine, ein elektrisches Handwerkzeug, eine Spritzgießmaschine, eine Blechbearbeitungsmaschine, eine Schweißanlage oder eine Lackieranlage sein.

Vorzugsweise ist auch ein Empfängermodul mit einem Empfänger-Stromanschluss des Empfängermoduls an das Stromnetz angeschlossen. Bevorzugt weist das Empfängermodul eine Verarbeitungseinrichtung auf, die dazu eingerichtet ist, über den Empfänger-Stromanschluss die Informationen über die Betriebsdaten aus dem Stromnetz zu empfangen. Besonders bevorzugt ist das Empfängermodul ein erfindungsgemäßes Empfängermodul.

### Erfindungsgemäßes Überwachungsverfahren

Schließlich betrifft die Erfindung ein Verfahren zum Überwachen einer Fertigungsmaschine in einem Fertigungsbetrieb gemäß Anspruch 15, mit den Schritten
a) Verbinden des Verbrauchers über ein erfindungsgemäßes Zwischenmodul mit dem Stromnetz,
b) Verbinden eines Empfängermoduls mit dem Stromnetz,
c) Ermitteln von Betriebsdaten des Verbrauchers in dem Zwischenmodul und Übertragen von Informationen über die ermittelten Betriebsdaten über den Eingangs-Stromanschluss des Zwischenmoduls in das Stromnetz,
d) Empfangen der Informationen über die Betriebsdaten aus dem Stromnetz in dem Empfängermodul,
   und vorzugsweise mit dem Schritt
e) Speichern und/oder Auswerten der Informationen über die Betriebsdaten in dem Empfängermodul.

Dieses Verfahren bietet eine einfache und flexible Möglichkeit den Betrieb eines Verbrauchers, der an ein dreiphasiges Stromnetz angeschlossen wird, zu überwachen, ohne dass es an dem Verbraucher und in dem Stromnetz fest installierter Überwachungseinrichtungen bedarf. Insbesondere kann mit dem erfindungsgemäßen Verfahren eine Überwachung von Fertigungsmaschinen in nicht oder nur zu einem geringen Grad digitalisierten Fertigungsbetrieben durchgeführt werden.

Erfindungsgemäß können in Schritt a) mehrere Verbraucher über je ein Zwischenmodul mit dem Stromnetz verbunden werden. Es ist typischerweise nur ein gemeinsames Empfängermodul vorgesehen, das die jeweiligen Informationen über die Betriebsdaten von jedem Zwischenmodul empfängt.

Die Schritte a) und b) können in der angegebenen oder umgekehrten Reihenfolge oder auch gleichzeitig durchgeführt werden.

Bevorzugt weist das Empfängermodul eine Verarbeitungseinrichtung auf, die dazu eingerichtet ist, über den Empfänger-Stromanschluss die Informationen über die Betriebsdaten aus dem Stromnetz zu empfangen. Besonders bevorzugt ist das Empfängermodul ein erfindungsgemäßes Empfängermodul.

Die Betriebsdaten werden in Schritt c) typischerweise kontinuierlich ermittelt. Die Informationen über die ermittelten Betriebsdaten können kontinuierlich oder in gewissen Zeitabständen, insbesondere über einen Zeitraum gesammelt, in das Stromnetz übertragen werden.

Beim Ermitteln von Betriebsdaten in Schritt c) kann eine Strom-, Spannungs-, Leistungs- und/oder Energiekennlinie des Verbrauchers mit einem Betriebszustand des Verbrauchers verknüpft werden. Mit andern Worten wird aus einer gemessenen Strom-, Spannungs-, Leistungs- und/oder Energieaufnahme des Verbrauchers anhand vorbekannter Muster für diesen Verbraucher oder Verbrauchertyp auf einen Betriebszustand des Verbrauchers geschlossen. Das Vorliegen eines bestimmten Betriebszustandes zählt hier zu den zu ermittelten Betriebsdaten. Informationen über diesen Betriebszustand werden sodann in das Stromnetz übertragen. Die Betriebszustände können vorzugsweise aus der Ferne überwacht, erkannt und/oder aufgezeichnet werden. Insbesondere können das Empfängermodul und das Zwischenmodul entfernt voneinander mit dem Stromnetz verbunden werden.

Das Ermitteln von Betriebsdaten in Schritt c) umfasst insbesondere, festzustellen, ob der Verbraucher aktiv ist, d.h. arbeitet, oder ob er nicht aktiv ist, d.h. nicht arbeitet. Für den Falle einer Fertigungsmaschine bedeutet dies, dass insbesondere festgestellt wird, ob die Fertigungsmaschine produktiv ist, d.h. ein Bauteil fertigt oder bearbeitet, oder ob sie nicht produktiv ist, d.h. keine Bearbeitungs- oder Fertigungsoperationen durchführt.

Vorzugsweise kann beim Ermitteln der Betriebsdaten in Schritt c) zwischen weiteren Betriebszuständen unterschieden werden. Insbesondere können folgende Betriebszustände des Verbrauchers unterschieden werden:
- Aus (keine Stromaufnahme),
- Standby (Ruhestrom),
- Start-up (charakteristisches Stromlastprofil beim Einschalten),
- Warm-up (charakteristisches Stromlastprofil beim Aufwärmen),
- Ready (Betriebsbereiter Verbraucher),
- Process (Verbraucher ist aktiv),
- Shut-Down (Maschine wird heruntergefahren und ausgeschaltet).

Diese Betriebszustände können insbesondere durch ihre unterschiedlichen, charakteristischen Verläufe der Strom- bzw. Leistungsaufnahme des Verbrauchers unterschieden werden. Die Informationen über die ermittelten Betriebsdaten können sich darauf beschränken, den identifizierten Betriebszustand zu bezeichnen.

Wenn der Verbraucher eine Fertigungsmaschine ist, die unterschiedliche Fertigungs- oder Bearbeitungsoperationen durchführen kann, kann im Rahmen des Betriebszustandes "Process" eine weitere Feinunterscheidung durchgeführt werden, dahingehend dass ermittelt wird, welche dieser Operationen durchgeführt wird und/oder welche Parameter dabei vorliegen. Beispielsweise ist es möglich festzustellen, ob eine Fertigungsoperation sich in einem fortschreitenden Stadium befindet oder ihr Ziel erreicht hat, wobei die Maschine weiter läuft. So kann etwa festgestellt werden, ob eine Sägemaschine noch im Eingriff ist (z.B. große Leistungsaufnahme), oder ob ein Bauteil durchgesägt wurde (Abfall der Leistungsaufnahme). Entsprechend kann beispielsweise festgestellt werden, ob ein Bauteil aus Aluminium (z.B. kleinere Leistungsaufnahme) oder aus Stahl (größere Leistungsaufnahme) bearbeitet wird.

Weitere Vorteile und vorteilhafte Ausgestaltungen des Gegenstands der Erfindung ergeben sich aus der Beschreibung, den Ansprüchen und der Zeichnung. Der Gegenstand der Erfindung wird durch die Ansprüche definiert. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Es zeigen:
- Fig. 1: eine schematische Darstellung eines erfindungsgemäßen Zwischenmoduls;
- Fig. 2a: eine schematische Darstellung eines erfindungsgemäßen Empfängermoduls mit drei Empfänger-Außenleiterkontakten, einem Empfänger-Neutralleiterkontakt und einem Empfänger-Schutzleiterkontakt;
- Fig. 2b: eine schematische Darstellung eines erfindungsgemäßen Empfängermoduls mit nur einem Empfänger-Außenleiterkontakt und einem Empfänger-Neutralleiterkontakt;
- Fig. 3: eine schematische Darstellung eines erfindungsgemäßen Überwachungssystems mit einem Stromnetz, mit zwei erfindungsgemäßen Zwischenmodulen, über die jeweils ein Verbraucher an das Stromnetz angeschlossen ist, und mit einem erfindungsgemäßen Empfängermodul;
- Fig. 4: ein Ablaufdiagramm eines erfindungsgemäßen Verfahrens zur Überwachung eines elektrischen Verbrauchers an einem Stromnetz mit drei Außenleitern; und
- Fig. 5: ein Ablaufdiagramm eines erfindungsgemäßen Verfahrens zur Inbetriebnahme eines erfindungsgemäßen Zwischenmoduls mit einem Anschluss für eine Kamera.

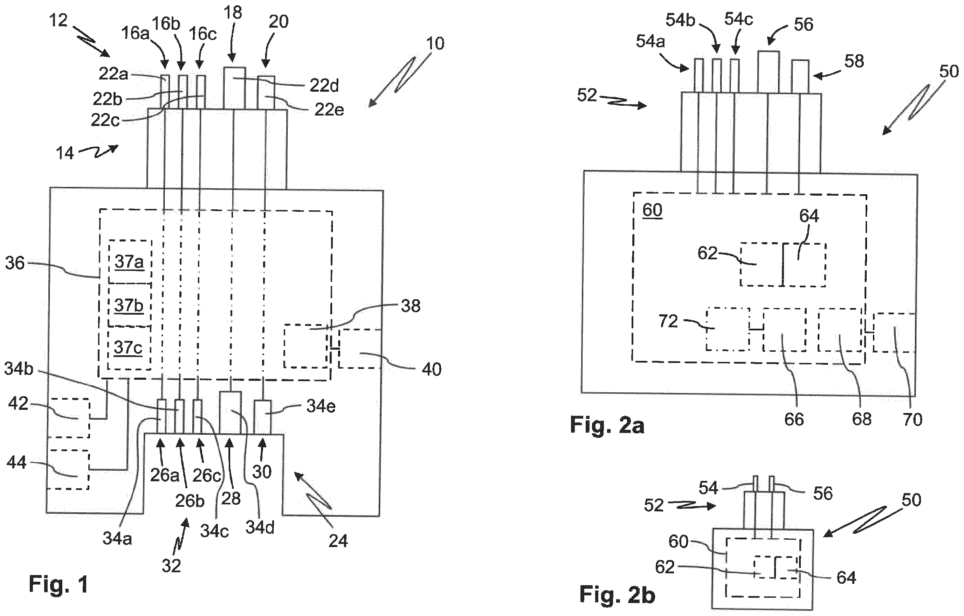

**Fig. 1** zeigt ein erfindungsgemäßes Zwischenmodul **10** in einer stark schematisierten Darstellung. Das Zwischenmodul 10 weist einen Eingangs-Stromanschluss **12** auf. Der Eingangs-Stromanschluss 12 ist hier als ein Zwischenmodul-Stecker **14** ausgebildet. Der Eingangs-Stromanschluss 12 umfasst drei Außenleiter-Eingangskontakte **16a, 16b**, **16c**. Ferner umfasst der Eingangs-Stromanschluss 12 einen Neutralleiter-Eingangskontakt **18** und einen Schutzleiter-Eingangskontakt **20**. Die Eingangskontakte 16a-c, 18, 20 des Eingangs-Stromanschlusses 12 sind hier jeweils als ein Steckerstift **22a-e** des Zwischenmodul-Steckers 14 ausgebildet. Der Zwischenmodul-Stecker 14 kann in eine Netz-Steckdose eines Stromnetzes eingesteckt werden, so dass die Eingangskontakte 16a-c, 18, 20 des Eingangs-Stromanschlusses 12 mit je einem Außenleiter bzw. Neutralleiter bzw. Schutzleiter des Stromnetzes elektrisch verbunden werden. Der Zwischenmodul-Stecker kann gemäß IEC 60309, insbesondere gemäß einer in der IEC 60309-2:1999 + A1:2005, modifiziert + A2:2012; deutsche Fassung EN 60309-2:1999 + A1:2007 + A2:2012 gezeigten Ausgestaltungen, gestaltet sein.

Das Zwischenmodul 10 weist auch einen Ausgangs-Stromanschluss **24** auf. Der Ausgangs-Stromanschluss 24 umfasst drei Außenleiter-Ausgangskontakte **26a**, **26b, 26c** sowie einen Neutralleiter-Ausgangskontakt **28** und einen Schutzleiter-Ausgangskontakt **30.** Der Ausgangs-Stromanschluss 24 ist hier als eine Zwischenmodul-Steckdose **32** ausgebildet, wobei die Ausgangskontakte 26a-c, 28, 30 jeweils als eine Einsteckbuchse **34a-e** gestaltet sind. Die Zwischenmodul-Steckdose 32 kann als eine CEE-Starkstrom-Steckdose ausgeführt sein. Diese Rundsteckvorrichtung wurde ursprünglich von der CEE (Commission internationale de reglementation en vue de l'approbation de l'équipement électrique) entworfen. Die Normierung der Industriesteckertypen wurde in der CEE 17 in den 1960er-Jahren durchgeführt, die 1968 im Vereinigten Königreich als BS 4343 übernommen und später zur IEC 60309 wurde. Daher kommt auch die aus der englischen "CEE-form plug" entlehnte Bezeichnung als CEE-Steckverbinder. In die Zwischenmodul-Steckdose 32 kann ein Anschlussstecker eines elektrischen Verbrauchers eingesteckt werden. Die Außenleiter-Ausgangskontakte 26a-c sind jeweils mit einem zugeordneten Außenleiter-Eingangskontakt 16a-c elektrisch verbunden. Entsprechend ist der Neutralleiter-Ausgangskontakt 28 mit dem Neutralleiter-Eingangskontakt 18 und der Schutzleiter-Ausgangskontakt 30 mit dem Schutzleiter-Eingangskontakt 20 elektrisch verbunden.

Das Zwischenmodul 10 ist dazu eingerichtet, Betriebsdaten eines Verbrauchers, der an das Zwischenmodul 10 angeschlossen ist, zu ermitteln und Informationen über die ermittelten Betriebsdaten in das Stromnetz, an das das Zwischenmodul 10 angeschlossen ist, zu übertragen. In der dargestellten Ausführungsform umfasst das Zwischenmodul 10 hierzu eine Überwachungseinrichtung **36**. Die Überwachungseinrichtung 36 kann auch zur Ausführung von weiteren Überwachungs-, Kontroll- und Steuerungsaufgaben des Zwischenmoduls 10 dienen. Die Überwachungseinrichtung 36 umfasst hier einen Mikro-Prozessor **37a**, eine Speichereinheit **37b** und eine elektronische Uhr **37c**. Zur Übertragung der Informationen über die Betriebsdaten in das Stromnetz ist in der Überwachungseinrichtung 36 ein OFDM-Verfahren implementiert.

Die Überwachungseinrichtung 36 steht in elektrischem Kontakt mit dem Eingangs-Stromanschluss 12 und dem Ausgangsstromanschluss 24 des Zwischenmoduls 10. Die Überwachungseinrichtung 36 kann insbesondere einen von einem der Eingangskontakte 16a-c, 18, 20 zu dem zugeordneten Ausgangskontakt 26a-c, 28, 30 fließenden Strom messen und/oder eine zwischen den Eingangskontakten 16a-c, 18, 20 bzw. den Ausgangskontakten 26a-c, 28, 30 anliegende Spannung messen. Die Messung erfolgt hier zeitlich aufgelöst. Die in das Stromnetz zu übertragenden Informationen über die Betriebsdaten werden mit entsprechenden Zeitinformationen versehen.

Die Überwachungseinrichtung 36 kann dazu eingerichtet werden, die Informationen über die Betriebsdaten nur über genau einen der Außenleiter-Eingangskontakte 26a-c oder über alle drei Außenleiter-Eingangskontakte 26a-c gemeinsam in das Stromnetz zu übertragen. Eine entsprechende Einstellung kann durch einen Befehl, der dem Zwischenmodul 10 über das Stromnetz übermittelt wird, vorgenommen werden.

Über das Stromnetz können dem Zwischenmodul 10 auch weitere Befehle übermittelt werden, beispielsweise zum Unterbrechen oder Aufnehmen der Versorgung des Verbrauchers mit elektrischer Energie. Die Überwachungseinrichtung 36 kann dazu einen nicht näher dargestellten Unterbrechungsschalter zwischen den Eingangskontakten 16a-c, 18, 20 und den Ausgangskontakten 26a-c, 28, 30 öffnen bzw. schließen.

Das Zwischenmodul 10 weist in der dargestellten Ausführungsform ferner eine WLAN-Schnittstelle **38**, eine LAN-Schnittstelle **40**, eine USB-Schnittstelle **42** und einen Anschluss **44** für eine Kamera auf. Der Anschluss 44 kann als eine (weitere) USB-Schnittstelle ausgeführt sein. Die WLAN-Schnittstelle 38 und die LAN-Schnittstelle 40 können insbesondere für Wartungs- und Diagnosezwecke eingesetzt werden, etwa zur Aktualisierung einer Firmware des Zwischenmoduls 10. Gleiches gilt für die USB-Schnittstelle 42. Diese kann weiterhin zum Anschließen von elektronischen Hilfsgeräten an das Zwischenmodul 10 verwendet werden, etwa von Sensoren für Umgebungsbedingungen. Mittels des Anschlusses 44 für die Kamera können von der Kamera aufgenommene Bilder auf das Zwischenmodul 10 übertragen werden.

**Fig. 2a** zeigt in stark schematisierter Weise eine erste Ausführungsform eines erfindungsgemäßen Empfängermoduls **50**. Das Empfängermodul 50 weist einen Empfänger-Stromanschluss **52** auf, mit dem das Empfängermodul 50 an ein Stromnetz angeschlossen werden kann. Der Empfänger-Stromanschluss 52 umfasst hier drei Empfänger-Außenleiterkontakte **54a-c**, einen Empfänger-Neutralleiterkontakt **56** und einen Empfänger-Schutzleiterkontakt **58**. Der Empfänger-Stromanschluss 52 kann ebenfalls als ein Starkstrom-Stecker gemäß IEC-60309 gestaltet sein.

Das Empfängermodul 50 weist eine Verarbeitungseinrichtung **60** auf. Die Verarbeitungseinrichtung 60 steht in direktem elektrischem Kontakt mit dem Empfänger-Stromanschluss 52. Mit anderen Worten ist die Verarbeitungseinrichtung 60 unmittelbar elektrisch leitend mit dem Empfänger-Stromanschluss 52 verbunden. Die Verarbeitungseinrichtung 60 dient zum Empfangen von Informationen über Betriebsdaten eines Verbrauchers aus dem Stromnetz, an das das Empfängermodul 50 angeschlossen ist. Das Empfängermodul 50 kann die Informationen über die Betriebsdaten des Verbrauchers über alle drei Empfänger-Außenleiterkontakte 54a-c empfangen. Die Verarbeitungseinrichtung 60 speichert diese Informationen. Die Verarbeitungseinrichtung 60 kann die Informationen auch auswerten und ggf. ein Ergebnis der Verarbeitung speichern. Die Verarbeitungseinrichtung 60 weist hierzu einen Mikro-Prozessor **62** und eine Speichereinheit **64** auf.

Die Verarbeitungseinrichtung 60 kann die empfangenen und gespeicherten Informationen bzw. Auswertungsergebnisse weiterleiten, beispielsweise an einen Server oder ein Mobiltelefon oder einen Laptop. Die Verarbeitungseinheit 60 weist hierzu einen Mobilfunkadapter **66**, einen WLAN-Adapter 68, und einen LAN-Adapter **70** (Ethernet-Schnittstelle)auf.

Das Empfängermodul 60 ist ferner dazu eingerichtet, Nachrichten betreffend die Informationen über die Betriebsdaten an ein Mobilgerät eines Benutzers zu senden. Die Verarbeitungseinrichtung 60 weist hierzu einen Chatbot **72** auf, welcher die Nachrichten über den Mobilfunkadapter 66 oder den WLAN-Adapter 68 versendet.

Weiterhin ist die Verarbeitungseinheit 60 dazu eingerichtet, Befehle entgegenzunehmen und diese über den Empfänger-Stromanschluss 52 in das Stromnetz zu übertragen. Zur Entgegennahme der Befehle dient ebenfalls der Chatbot 72, welchem die Befehle über den Mobilfunkadapter 66 oder den WLAN-Adapter 68 in Form von Textnachrichten zugeführt werden können. Die Befehle werden von dem Empfängermodul 50 über den Empfänger-Stromanschluss 52 in das Stromnetz übermittelt, wo sie beispielsweise von einem erfindungsgemäßen Zwischenmodul empfangen werden. Vor der Übermittlung in das Stromnetz kann die Verarbeitungseinrichtung 60 die Befehle für das Zwischenmodul aufbereiten.

**Fig. 2b** zeigt in stark schematisierter Weise eine zweite Ausführungsform eines erfindungsgemäßen Empfängermoduls 50. Das Empfängermodul 50 weist einen Empfänger-Stromanschluss 52 auf, mit dem das Empfängermodul 50 an ein Stromnetz angeschlossen werden kann. Der Empfänger-Stromanschluss 52 umfasst hier genau einen Empfänger-Außenleiterkontakt **54** und einen Empfänger-Neutralleiterkontakt 56. Das Empfängermodul 50 in der zweiten Ausführungsform kann somit an eine einphasige Steckdose des Stromnetzes angeschlossen werden. In Aufbau und Funktion entspricht das Empfängermodul 50 in der zweiten Ausführungsform ansonsten der ersten Ausführungsform des Empfängermoduls gemäß Fig. 2a.

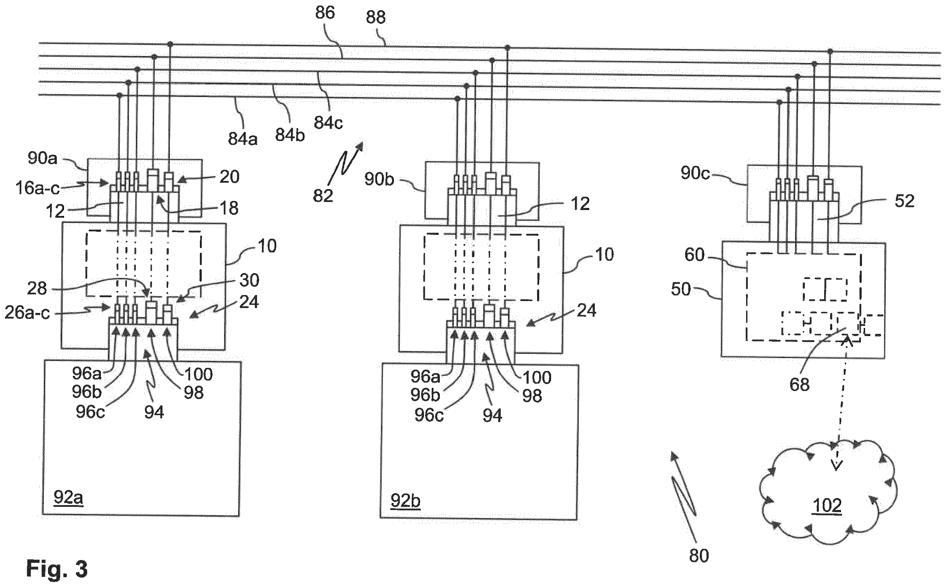

**Fig. 3** zeigt ein erfindungsgemäßes Überwachungssystem **80** in einer stark schematisierten Darstellung. Das Überwachungssystem 80 umfasst ein Stromnetz **82** mit drei Außenleitern **84a, 84b, 84c,** einem Neutralleiter **86** und einem Schutzleiter **88**. Das Stromnetz 82 umfasst ferner mehrere Netz-Steckdosen **90a**, **90b**, **90c**, die jeweils mit allen Leitern 84a-c, 86, 88 des Stromnetzes 82 elektrisch verbunden sind. Die Netz-Steckdosen 90a-c sind hier jeweils als CEE-Starkstrom-Steckdosen ausgeführt.

Weiter weist das Überwachungssystem 80 zwei erfindungsgemäße Zwischenmodule 10 auf. Über die Zwischenmodule 10 sind zwei elektrische Verbraucher **92a**, **92b** an das Stromnetz 82 angeschlossen. Der Verbraucher 92a ist hier eine Fräsmaschine; der Verbraucher 92b ist hier ein Schweißroboter. Die Zwischenmodule 10 entsprechen in Aufbau und Funktion dem Zwischenmodul von Fig. 1. Die Verbraucher 92a, 92b weisen jeweils einen Verbraucher-Stromanschluss **94** mit drei Außenleiter-Eingängen **96a**, **96b**, **96c**, einem Neutralleiter-Eingang **98** und einem Schutzleiter-Eingang **100** auf. Es versteht sich, dass die Verbraucher-Stromanschlüsse 94 in der Praxis nicht unmittelbar an einem Gehäuse der Verbraucher 92a, 92b ausgebildet sind, sondern üblicherweise jeweils über ein Kabel mit den Verbrauchern 92a, 92b verbunden sind.

Das Überwachungssystem 80 umfasst weiterhin ein erfindungsgemäßes Empfängermodul 50, welches über die Netz-Steckdose 90c an das Stromnetz 82 angeschlossen ist. Das Empfängermodul 50 entspricht hier der Ausführungsform gemäß Fig. 2a.

In einer nicht dargestellten, alternativen Ausführungsform des erfindungsgemäßen Überwachungssystems kann das Empfängermodul der Ausführungsform gemäß Fig. 2b entsprechen und über eine einphasige Steckdose (Schuko-Steckdose) des Stromnetzes mit nur einem der Außenleiter des Stromnetzes und dem Neutralleiter des Stromnetzes verbunden sein.

Beim Betrieb der Verbraucher 92a, 92b ermitteln die Zwischenmodule 10 jeweils Betriebsdaten ihres Verbrauchers 92a, 92b und übertragen Informationen zu diesen Betriebsdaten über ihren jeweiligen Eingangs-Stromanschluss 12 in das Stromnetz 82. Für die Übertragung fügen die Zwischenmodule 10 den Informationen über die Betriebsdaten jeweils Individualisierungsmerkmale hinzu. Dadurch können die Informationen über die Betriebsdaten später einem der Zwischenmodule 10 und dem an ihm angeschlossenen Verbraucher 92a, 92b zugeordnet werden.

Das Empfängermodul 50 empfängt die Informationen über die Betriebsdaten und die Individualisierungsmerkmale aus dem Stromnetz 82 und speichert sie. Bei Bedarf wertet das Empfängermodul 50 die Informationen aus und kann auch ein Auswertungsergebnis speichern. Zur weiteren Analyse und Archivierung sendet das Empfängermodul 50 die Informationen über die Betriebsdaten und ggf. die Auswertungsergebnisse an eine übergeordnete Instanz **102**. Die übergeordnete Instanz 102 ist hier ein Cloud-Speicher, mit dem das Empfängermodul 50 über seinen WLAN-Adapter 68 kommuniziert.

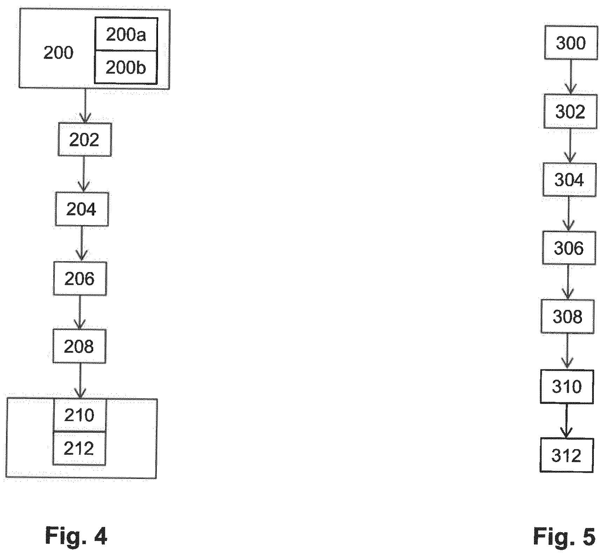

**Fig. 4** zeigt einen Ablaufplan eines erfindungsgemäßen Verfahrens zum Überwachen eines elektrischen Verbrauchers an einem Stromnetz mit drei Außenleitern. Das Verfahren kann beispielsweise mit dem erfindungsgemäßen Überwachungssystem 80 gemäß Fig. 3 durchgeführt werden.

In einem Schritt **200** wird der Verbraucher über ein erfindungsgemäßes Zwischenmodul an das Stromnetz angeschlossen. Der Schritt 200 umfasst das Verbinden **200a** des Zwischenmoduls mit dem Stromnetz und das Verbinden **200b** des Verbrauchers mit dem Zwischenmodul. Weiterhin wird in einem Schritt **202** ein, vorzugsweise erfindungsgemäßes, Empfängermodul mit dem Stromnetz verbunden.

Sodann kann der Verbraucher an dem Stromnetz betrieben werden. In einem Schritt **204** werden in dem Zwischenmodul Betriebsdaten des Verbrauchers ermittelt und es werden in einem Schritt **206** Informationen über die ermittelten Betriebsdaten über den Eingangs-Stromanschluss des Zwischenmoduls in das Stromnetz übertragen. Diese Informationen werden in einem Schritt **208** von dem Empfängermodul aus dem Stromnetz empfangen. Schließlich können die Informationen über die Betriebsdaten in einem Schritt **210** in dem Empfängermodul gespeichert werden und/oder in einem Schritt **212** in dem Empfängermodul ausgewertet werden.

**Fig. 5** zeigt ein Ablaufplan eines erfindungsgemäßen Verfahrens zur Inbetriebnahme eines erfindungsgemäßen Zwischenmoduls mit einem Anschluss für eine Kamera.

In einem Schritt 300 wird das Zwischenmodul an ein Stromnetz mit drei Außenleitern angeschlossen. In einem Schritt 302 wird ein Verbraucher an das Zwischenmodul angeschlossen. In einem Schritt 304 wird eine Kamera an das Zwischenmodul angeschlossen. In einem Schritt 306 wird ein Bild des Verbrauchers mit der Kamera aufgenommen. Dieses Bild wird sodann in einem Schritt 308 vermittels des Zwischenmoduls in das Stromnetz übertragen. Daraufhin erfolgt in einem Schritt 310 ein Abgleichen des Bildes mit weiteren Bildern bekannter Verbrauchertypen, um den Verbraucher zu identifizieren. Der Schritt 310 kann in einem erfindungsgemäßen Empfängermodul oder in einer übergeordneten Instanz durchgeführt werden. In letzterem Fall kann das Bild der übergeordneten Instanz von dem Empfängermodul übermittelt werden. Schließlich wird in einem Schritt 312 die Zuordnung des Zwischenmoduls und des erkannten Verbrauchertyps gespeichert. Das Speichern kann in der übergeordneten Instanz und/oder einem Empfängermodul und/oder dem Zwischenmodul erfolgen.

## Patentansprüche

1. Überwachungssystem (80) für einen Fertigungsbetrieb der Metall- und/oder Blechbearbeitung zum Überwachen eines elektrischen Verbrauchers (92a, 92b), umfassend
- den Verbraucher (92a, 92b) in Form einer Fertigungsmaschine zur Bearbeitung von Blech und/oder Metall,
- ein Stromnetz (82) mit drei Außenleitern (84a-c),
- ein Zwischenmodul (10), über welches der Verbraucher (92a, 92b) an das Stromnetz (82) anschließbar ist, mit einem Eingangs-Stromanschluss (12) zum Anschließen des Zwischenmoduls (10) an das Stromnetz (82), wobei der Eingangs-Stromanschluss (12) drei Außenleiter-Eingangskontakte (16a-c) zum Kontaktieren je eines Außenleiters (84a-c) des Stromnetzes (82) aufweist, und mit einem Ausgangs-Stromanschluss (24) zum Anschließen des Verbrauchers (92a, 92b) an das Zwischenmodul (10), wobei das Zwischenmodul (10) dazu eingerichtet ist, Betriebsdaten des Verbrauchers (92a, 92b) zu ermitteln und über den Eingangs-Stromanschluss (12) Informationen über die ermittelten Betriebsdaten in das Stromnetz (82) zu übertragen, wobei das Zwischenmodul (10) dazu eingerichtet ist, wenigstens einen Parameter eines elektrischen Stroms zu messen, der im Betrieb von dem Stromnetz (82) durch das Zwischenmodul (10) zu dem Verbraucher (92a, 92b) fließt,
- ein Empfängermodul (50) zum Empfangen von Informationen über Betriebsdaten des Verbrauchers (92a, 92b) aus dem Stromnetz (82),
wobei das Empfängermodul (50) einen Empfänger-Stromanschluss (52) zum Anschließen des Empfängermoduls (50) an das Stromnetz (82), und eine Verarbeitungseinrichtung (60) aufweist, die dazu eingerichtet ist, über den Empfänger-Stromanschluss (52) die Informationen über die Betriebsdaten aus dem Stromnetz (82) zu empfangen,
wobei das Zwischenmodul (10) einen Anschluss (44) für eine Kamera aufweist und dazu eingerichtet ist, ein von der Kamera empfangenes Bild in das Stromnetz (82) zu übertragen.

2. Überwachungssystem (80) nach Anspruch 1, **dadurch gekennzeichnet, dass** das Zwischenmodul (10) dazu eingerichtet ist, die Informationen über die Betriebsdaten über genau einen der Außenleiter-Eingangskontakte (16a-c) zu übertragen.

3. Überwachungssystem (80) nach Anspruch 1 oder 2, **dadurch gekennzeichnet, dass** das Zwischenmodul (10) dazu eingerichtet ist, die Informationen über die Betriebsdaten über wenigstens zwei, vorzugsweise über alle, Außenleiter-Eingangskontakte (16a-c) zu übertragen.

4. Überwachungssystem (80) nach einem der vorhergehenden Ansprüche, **dadurch gekennzeichnet, dass** der Eingangs-Stromanschluss (12) als ein Zwischenmodul-Stecker (14) zum Einstecken in eine Steckdose (92a, 92b) ausgebildet ist, insbesondere wobei die Eingangskontakte (16a-c, 18, 20) des Eingangs-Stromanschlusses (12) jeweils als ein Steckerstift (22a-e) ausgebildet sind.

5. Überwachungssystem (80) nach einem der vorhergehenden Ansprüche, **dadurch gekennzeichnet, dass** der Ausgangs-Stromanschluss (24) je einen zugeordneten Ausgangskontakt (26a-c, 28, 30) für jeden der Eingangskontakte (16a-c, 18, 20) des Eingangs-Stromanschlusses (12) aufweist.

6. Überwachungssystem (80) nach einem der vorhergehenden Ansprüche, **dadurch gekennzeichnet, dass** der Ausgangs-Stromanschluss (24) als eine Zwischenmodul-Steckdose (32) zum Einstecken eines Steckers ausgebildet ist, insbesondere wobei die Ausgangskontakte (26a-c, 28, 30) des Ausgangs-Stromanschlusses (24) jeweils als eine Einsteckbuchse (34a-e) ausgebildet sind.

7. Überwachungssystem (80) nach einem der vorhergehenden Ansprüche, **dadurch gekennzeichnet, dass** das Zwischenmodul (10) dazu eingerichtet ist, die Betriebsdaten zeitaufgelöst zu ermitteln, und dass die Information über die ermittelten Betriebsdaten Zeitinformationen umfassen.

8. Überwachungssystem (80) nach einem der vorhergehenden Ansprüche, **dadurch gekennzeichnet, dass** das Zwischenmodul (10) dazu eingerichtet ist, über den Eingangs-Stromanschluss (12) Befehle aus dem Stromnetz (82) entgegenzunehmen.

9. Überwachungssystem (80) nach einem der vorhergehenden Ansprüche, **dadurch gekennzeichnet, dass** das Zwischenmodul (10) eine LAN-Schnittstelle (40) und/oder eine WLAN-Schnittstelle (38) aufweist.

10. Überwachungssystem (80) nach einem der vorhergehenden Ansprüche, **dadurch gekennzeichnet, dass** die Verarbeitungseinrichtung (60) in direktem elektrischem Kontakt mit dem Empfänger-Stromanschluss (52) steht, und dazu eingerichtet ist, die Informationen über die Betriebsdaten zu speichern und/oder auszuwerten.

11. Überwachungssystem (80) nach einem der vorhergehenden Ansprüche, **dadurch gekennzeichnet, dass** das Empfängermodul (50) dazu eingerichtet ist, Nachrichten betreffend die Informationen über die Betriebsdaten an ein Mobilgerät eines Benutzers zu senden.

12. Überwachungssystem (80) nach einem der vorhergehenden Ansprüche, **dadurch gekennzeichnet, dass** das Empfängermodul (50) dazu eingerichtet ist, Befehle entgegenzunehmen, insbesondere von einem Mobilgerät eines Benutzers, und diese Befehle über den Empfänger-Stromanschluss (52) in das Stromnetz (82) zu übermitteln.

13. Überwachungssystem (80) nach einem der vorhergehenden Ansprüche, **dadurch gekennzeichnet,**
**dass** das Stromnetz (82) weiterhin einen Neutralleiter (86) umfasst, dass der Empfänger-Stromanschluss (52) des Empfängermoduls (50) einen Empfänger-Außenleiterkontakt (54) zum Verbinden des Empfängermoduls (50) mit einem der Außenleiter (84a-c) des Stromnetzes (82) und einen Empfänger-Neutralleiterkontakt (56) zum Verbinden des Empfängermoduls (50) mit dem Neutralleiter (86) des Stromnetzes (82) aufweist.

14. Verwendung eines Überwachungssystems (80) nach einem der Ansprüche 1 bis 13 zum Überwachen des elektrischen Verbrauchers (92a, 92b) in Form einer Fertigungsmaschine zur Bearbeitung von Blech und/oder Metall, wobei der Verbraucher (92a, 92b) über das Zwischenmodul (10) an das Stromnetz (82) mit drei Außenleitern (84a-c) angeschlossen ist.

15. Verfahren zum Überwachen einer Fertigungsmaschine in einem Fertigungsbetrieb mit dem Überwachungssystem nach einem der Ansprüche 1 bis 13, wobei die Fertigungsmaschine als ein elektrischer Verbraucher (92a, 92b) an ein Stromnetz (82) mit drei Außenleitern (84a-c) anschließbar ist, mit den Schritten
a) Verbinden (200) der Fertigungsmaschine über das Zwischenmodul (10) mit dem Stromnetz (82), wobei das Zwischenmodul (10) den Eingangs-Stromanschluss (12) zum Anschließen des Zwischenmoduls (10) an das Stromnetz (82) und den Ausgangs-Stromanschluss (24) zum Anschließen der Fertigungsmaschine an das Zwischenmodul (10) aufweist, wobei das Zwischenmodul (10) dazu eingerichtet ist, Betriebsdaten der Fertigungsmaschine zu ermitteln und über den Eingangs-Stromanschluss (12) Informationen über die ermittelten Betriebsdaten in das Stromnetz (82) zu übertragen, und wobei der Eingangs-Stromanschluss (12) drei Außenleiter-Eingangskontakte (16a-c) zum Kontaktieren je eines Außenleiters (84a-c) des Stromnetzes (82) aufweist,
b) Verbinden (202) des Empfängermoduls (50) mit dem Stromnetz (82),
c) Ermitteln (204) von Betriebsdaten des Verbrauchers (92a, 92b) in dem Zwischenmodul (10) und Übertragen (206) von Informationen über die ermittelten Betriebsdaten über den Eingangs-Stromanschluss (12) des Zwischenmoduls (10) in das Stromnetz (82),
d) Empfangen (108) der Informationen über die Betriebsdaten aus dem Stromnetz (82) in dem Empfängermodul (50),
e) Speichern (210) und/oder Auswerten (212) der Informationen über die Betriebsdaten in dem Empfängermodul (50).

## Claims

1. A monitoring system (80) for a production operation of metal and/or sheet metal processing for monitoring an electrical consumer (92a, 92b), comprising
- the consumer (92a, 92b) in the form of a production machine for processing sheet metal and/or metal,
- a power grid (82) with three phase conductors (84a-c),
- an intermediate module (10) via which the consumer (92a, 92b) can be connected to the power grid (82), with an input power connection (12) for connecting the intermediate module (10) to the power grid (82), wherein the input power connection (12) has three phase conductor input contacts (16a-c) for contacting one phase conductor (84a-c) each of the power grid (82), and with an output power connection (24) for connecting the consumer (92a, 92b) to the intermediate module (10), wherein the intermediate module (10) is set up to determine the operating data of the consumer (92a, 92b) and to transmit information about the determined operating data to the power grid (82) via the input power connection (12), wherein the intermediate module (10) is set up to measure at least one parameter of an electric current that flows during operation from the power grid (82) through the intermediate module (10) to the consumer (92a, 92b),
- a receiver module (50) for receiving information about operating data of the consumer (92a, 92b) from the power grid (82),
wherein the receiver module (50) has a receiver power connection (52) for connecting the receiver module (50) to the power grid (82), and a processing device (60) which is set up to receive the information about the operating data from the power grid (82) via the receiver power connection (52),
wherein the intermediate module (10) has a connection (44) for a camera and is set up to transmit an image received from the camera to the power grid (82).

2. The monitoring system (80) according to Claim 1, **characterised in that** the intermediate module (10) is set up to transmit the information about the operating data via exactly one of the phase conductor input contacts (16a-c).

3. The monitoring system (80) according to Claim 1 or 2, **characterised in that** the intermediate module (10) is set up to transmit the information about the operating data via at least two, preferably via all, phase conductor input contacts (16a-c).

4. The monitoring system (80) according to one of the preceding claims, **characterised in that** the input power connection (12) is designed as an intermediate module plug (14) for plugging into a socket (92a, 92b), in particular wherein the input contacts (16a-c, 18, 20) of the input power connection (12) are each designed as a plug pin (22a-e).

5. The monitoring system (80) according to one of the preceding claims, **characterised in that** the output power connection (24) has an assigned output contact (26a-c, 28, 30) for each of the input contacts (16a-c, 18, 20) of the input power connection (12).

6. The monitoring system (80) according to one of the preceding claims, **characterised in that** the output power connection (24) is designed as an intermediate module socket (32) for plugging in a plug, in particular wherein the output contacts (26a-c, 28, 30) of the output power connection (24) are each designed as a plug-in socket (34a-e).

7. The monitoring system (80) according to one of the preceding claims, **characterised in that** the intermediate module (10) is set up to determine the operating data in a time-resolved manner, and **in that** the information about the determined operating data comprises time information.

8. The monitoring system (80) according to one of the preceding claims, **characterised in that** the intermediate module (10) is set up to receive commands from the power grid (82) via the input power connection (12).

9. The monitoring system (80) according to one of the preceding claims, **characterised in that** the intermediate module (10) has a LAN interface (40) and/or a WLAN interface (38).

10. The monitoring system (80) according to one of the preceding claims, **characterised in that** the processing device (60) is in direct electrical contact with the receiver power connection (52) and is set up to store and/or evaluate the information about the operating data.

11. The monitoring system (80) according to one of the preceding claims, **characterised in that** the receiver module (50) is set up to send messages relating to the information about the operating data to a mobile device of a user.

12. The monitoring system (80) according to one of the preceding claims, **characterised in that** the receiver module (50) is set up to receive commands, in particular from a mobile device of a user, and to transfer these commands to the power grid (82) via the receiver power connection (52).

13. The monitoring system (80) according to one of the preceding claims, **characterised in that**
the power grid (82) further comprises a neutral conductor (86), that the receiver power connection (52) of the receiver module (50) has a receiver phase conductor contact (54) for connecting the receiver module (50) to one of the phase conductors (84a-c) of the power grid (82) and a receiver neutral conductor contact (56) for connecting the receiver module (50) to the neutral conductor (86) of the power grid (82).

14. A use of a monitoring system (80) according to one of Claims 1 to 13 for monitoring the electrical consumer (92a, 92b) in the form of a production machine for processing sheet metal and/or metal, wherein the consumer (92a, 92b) is connected via the intermediate module (10) to the power grid (82) with three phase conductors (84a-c).

15. A method for monitoring a production machine in a production operation with the monitoring system according to one of Claims 1 to 13, wherein the production machine can be connected as an electrical consumer (92a, 92b) to a power grid (82) with three phase conductors (84a-c), comprising the steps of
a) Connecting (200) the production machine to the power grid (82) via the intermediate module (10), wherein the intermediate module (10) has the input power connection (12) for connecting the intermediate module (10) to the power grid (82) and the output power connection (24) for connecting the production machine to the intermediate module (10), wherein the intermediate module (10) is set up to determine operating data of the production machine and to transmit information about the determined operating data to the power grid (82) via the input power connection (12), and wherein the input power connection (12) has three phase conductor input contacts (16a-c) for contacting one phase conductor (84a-c) each of the power grid (82),
b) Connecting (202) the receiver module (50) to the power grid (82),
c) Determining (204) operating data of the consumer (92a, 92b) in the intermediate module (10) and transmitting (206) information about the determined operating data via the input power connection (12) of the intermediate module (10) to the power grid (82),
d) Receiving (108) the information about the operating data from the power grid (82) in the receiver module (50),
e) Storing (210) and/or evaluating (212) the information about the operating data in the receiver module (50).

## Revendications

1. Système de surveillance (80) d'une installation de fabrication par usinage du métal et/ou de la tôle permettant de surveiller un consommateur électrique (92a, 92b), comprenant
- le consommateur (92a, 92b) sous forme d'une machine de fabrication destinée à l'usinage de la tôle et/ou du métal,
- un réseau électrique (82) avec trois conducteurs externes (84a-c),
- un module intermédiaire (10) au moyen duquel le consommateur (92a, 92b) peut être connecté au réseau électrique (82), comportant une connexion électrique d'entrée (12) permettant de connecter le module intermédiaire (10) au réseau électrique (82), dans lequel la connexion électrique d'entrée (12) comporte trois contacts d'entrée (16a-c) des conducteurs externes permettant de contacter respectivement un conducteur externe (84a-c) au réseau électrique (82), et comportant une connexion électrique de sortie (24) permettant de connecter le consommateur (92a, 92b) au module intermédiaire (10), dans lequel le module intermédiaire (10) est conçu pour déterminer les données de service du consommateur (92a, 92b) et pour transmettre des informations sur les données de service déterminées au réseau électrique (82) par l'intermédiaire de la connexion électrique d'entrée (12), dans lequel le module intermédiaire (10) est conçu pour mesurer au moins un paramètre d'un courant électrique, lequel circule pendant le fonctionnement du réseau électrique (82) à travers le module intermédiaire (10) vers le consommateur (92a, 92b),
- un module récepteur (50) permettant de recevoir du réseau électrique (82) des informations sur les données de service du consommateur (92a, 92b),
dans lequel le module récepteur (50) comporte une connexion électrique (52) récepteur permettant de connecter le module récepteur (50) au réseau électrique (82), et un dispositif de traitement (60), lequel est conçu pour recevoir par l'intermédiaire de la connexion électrique (52) récepteur les informations sur les données de service provenant du réseau électrique (82),
dans lequel le module intermédiaire (10) comporte une connexion (44) pour une caméra et est conçu pour transmettre au réseau électrique (82) une image reçue de la caméra.

2. Système de surveillance (80) selon la revendication 1, **caractérisé en ce que** le module intermédiaire (10) est conçu pour transmettre les informations sur les données de service par l'intermédiaire d'exactement un des contacts d'entrée (16a-c) des conducteurs externes.

3. Système de surveillance (80) selon la revendication 1 ou 2, **caractérisé en ce que** le module intermédiaire (10) est conçu pour transmettre les informations sur les données de service par l'intermédiaire d'au moins deux, de préférence par l'intermédiaire de tous les contacts d'entrée (16a-c) des conducteurs externes.

4. Système de surveillance (80) selon l'une quelconque des revendications précédentes, **caractérisé en ce que** la connexion électrique d'entrée (12) est conçue sous forme d'une fiche (14) module intermédiaire destinée à être enfichée dans une prise électrique (92a, 92b), en particulier dans lequel les contacts d'entrée (16a-c, 18, 20) de la connexion électrique d'entrée (12) sont respectivement conçus sous la forme d'une fiche mâle (22a-e).

5. Système de surveillance (80) selon l'une quelconque des revendications précédentes, **caractérisé en ce que** la connexion électrique de sortie (24) comporte un contact de sortie (26a-c, 28, 30) associé respectivement à chacun des contacts d'entrée (16a-c, 18, 20) de la connexion électrique d'entrée (12).

6. Système de surveillance (80) selon l'une quelconque des revendications précédentes, **caractérisé en ce que** la connexion électrique de sortie (24) est conçue sous la forme d'une prise électrique (32) module intermédiaire permettant d'enficher une fiche, en particulier dans lequel les contacts de sortie (26a-c, 28, 30) de la connexion électrique de sortie (24) sont respectivement conçus sous la forme d'une douille enfichable (34a-e).

7. Système de surveillance (80) selon l'une quelconque des revendications précédentes, **caractérisé en ce que** le module intermédiaire (10) est conçu pour déterminer les données de service de manière résolue dans le temps, et **en ce que** les informations sur les données de service déterminées comprennent des informations temporelles.

8. Système de surveillance (80) selon l'une quelconque des revendications précédentes, **caractérisé en ce que** le module intermédiaire (10) est conçu pour recevoir, par l'intermédiaire de la connexion électrique d'entrée (12), des instructions provenant du réseau électrique (82).

9. Système de surveillance (80) selon l'une quelconque des revendications précédentes, **caractérisé en ce que** le module intermédiaire (10) comporte une interface LAN (40) et/ou une interface WLAN (38).

10. Système de surveillance (80) selon l'une quelconque des revendications précédentes, **caractérisé en ce que** le dispositif de traitement (60) est en contact électrique direct avec la connexion électrique (52) du récepteur et est conçu pour enregistrer et/ou évaluer les informations sur les données de service.

11. Système de surveillance (80) selon l'une quelconque des revendications précédentes, **caractérisé en ce que** le module récepteur (50) est conçu pour envoyer des messages relatifs aux informations sur les données de service à un appareil mobile d'un utilisateur.

12. Système de surveillance (80) selon l'une quelconque des revendications précédentes, **caractérisé en ce que** le module récepteur (50) est conçu pour recevoir des instructions, en particulier provenant d'un appareil mobile d'un utilisateur, et pour transmettre lesdites instructions au réseau électrique (82) par l'intermédiaire de la connexion électrique (52) du récepteur.

13. Système de surveillance (80) selon l'une quelconque des revendications précédentes, **caractérisé en ce**
**que** le réseau électrique (82) comprend en outre un conducteur neutre (86), que la connexion électrique (52) du récepteur du module récepteur (50) comporte un contact de conducteur externe (54) du récepteur permettant de connecter le module récepteur (50) à l'un des conducteurs externes (84a-c) du réseau électrique (82) et un contact de conducteur neutre (56) du récepteur permettant de connecter le module récepteur (50) au conducteur neutre (86) du réseau électrique (82).

14. Utilisation d'un système de surveillance (80) selon l'une quelconque des revendications 1 à 13 permettant de surveiller le consommateur (92a, 92b) électrique sous la forme d'une machine de fabrication destinée au traitement de la tôle et/ou du métal, dans laquelle le consommateur (92a, 92b) est connecté par l'intermédiaire du module intermédiaire (10) au réseau électrique (82) à l'aide de trois conducteurs externes (84a-c).

15. Procédé de surveillance d'une machine de fabrication dans une installation de fabrication comportant le système de surveillance selon l'une quelconque des revendications 1 à 13, dans lequel la machine de fabrication peut être connectée comme consommateur (92a, 92b) électrique à un réseau électrique (82) à l'aide de trois conducteurs externes (84a-c), comportant les étapes suivantes
a) connexion (200) de la machine de fabrication, par l'intermédiaire du module intermédiaire (10), au réseau électrique (82), dans lequel le module intermédiaire (10) comporte la connexion électrique d'entrée (12) permettant de connecter le module intermédiaire (10) au réseau électrique (82) et la connexion électrique de sortie (24) permettant de connecter la machine à usiner au module intermédiaire (10), dans lequel le module intermédiaire (10) est conçu pour déterminer des données de service de la machine de fabrication et pour transmettre, par l'intermédiaire de la connexion électrique d'entrée (12), des informations au réseau électrique (82) sur les données de service déterminées, et dans lequel la connexion électrique d'entrée (12) comporte trois contacts d'entrée (16a-c) des conducteurs externes permettant de contacter respectivement un conducteur externe (84a-c) du réseau électrique (82),
b) connexion (202) du module récepteur (50) au réseau électrique (82),
c) détermination (204) des données de service du consommateur (92a, 92b) dans le module intermédiaire (10) et transmission (206) au réseau électrique (82) des informations sur les données de service déterminées par l'intermédiaire de la connexion électrique d'entrée (12) du module intermédiaire (10),
d) réception (108) dans le module récepteur (50) des informations sur les données de service provenant du réseau électrique (82),
e) enregistrement (210) et/ou évaluation (212) dans le module récepteur (50) des informations sur les données de service.
